Europäisches Patentamt

European Patent Office

Office européen des brevets

(19)

(11)  EP 0 678 598 B1

(12)  # EUROPEAN PATENT SPECIFICATION

(45) Date of publication and mention
of the grant of the patent:
**02.12.1998  Bulletin 1998/49**

(51) Int Cl.6: **C30B 5/00**, C30B 7/00,
C23C 18/12

(21) Application number: **95105954.2**

(22) Date of filing: **21.04.1995**

(54) **Oxide dielectric thin film and preparation thereof**

Dielektrischer Oxid-Dünnfilm sowie dessen Herstellung

Film mince d'oxyde diélectrique et sa méthode de préparation

(84) Designated Contracting States:
**DE FR GB**

(30) Priority: **22.04.1994  JP 84411/94**

(43) Date of publication of application:
**25.10.1995  Bulletin 1995/43**

(73) Proprietor: **SUMITOMO ELECTRIC INDUSTRIES,
LTD
Osaka-shi, Osaka-fu 541 (JP)**

(72) Inventors:
- **Tanaka, Motoyuki, c/o Itami Works of
Itami-shi, Hyogo-ken (JP)**
- **Imai, Takahiro, c/o Itami Works of
Itami-shi, Hyogo-ken (JP)**
- **Fujimori, Naoji, c/o Itami Works of
Itami-shi, Hyogo-ken (JP)**

(74) Representative:
**Hansen, Bernd, Dr. Dipl.-Chem. et al
Hoffmann Eitle,
Patent- und Rechtsanwälte,
Arabellastrasse 4
81925 München (DE)**

(56) References cited:
**US-A- 4 946 710**

- **MATERIALS LETTERS, vol.10, no.7/8, January
1991, AMSTERDAM NL pages 348 - 354
NASHIMOTO 'epitaxial LiNbO3 thin films
prepared by a sol-gel process'**
- **THIRD EURO-CERAMICS, vol.2, 12 September
1993, SPAIN pages 685 - 698 HIRANO
'processing of better ferroelectric films through
chemistry'**

## Description

### BACKGROUND OF THE INVENTION

#### FIELD OF THE INVENTION

The present invention relates to a process for preparing an oxide dielectric thin film for use in optical waveguides, optical switches, modulators, optical deflecting elements and the like.

#### DESCRIPTION OF THE RELATED ART

Ferroelectric materials are used in a variety of electronic devices. Among them, oxide dielectric materials are expected to find applications, for example, in non-volatile memories, capacitors, optical waveguides, optical switches, modulators, optical deflecting elements, etc. and many researches have been carried out thereon, since many of them have characteristics such as piezoelectricity, pyroelectricity and elctrooptical effect.

In application of the oxide dielectric materials to electronic devices which have increasing tendencies to short, small, light weight and thin devices, it is crucial to make the oxide dielectric material into a thin film. In addition, in order to efficiently develop characteristics of the oxide dielectric thin film, it is desired that one of crystal axes of each crystal of the oxide dielectric thin film is oriented in the same direction, and further that all the crystal axes are in the same directions, respectively.

For example, Japanese Patent Kokai No. 281500/1993 discloses a lithium niobate thin film which is prepared by a sol-gel process using $LiOC_2H_4OCH_3$ and $Nb(OC_2H_4OCH_3)_5$ as starting materials in order to uniaxially orient one of crystal axes of each crystal in the oxide dielectric thin film. According to the disclosure, an oxide dielectric thin film is formed on a (001) plane of a sapphire single crystal substrate. The thin film is crystalline and has a half-value width of 2.70 degrees in the X-ray diffraction peak using a Cu-K$\alpha$ radiation for a (006) plane of $LiNbO_3$.

In conventional processes for forming oxide dielectric thin films, particularly using the sol-gel process, orientation of crystal axes of each crystal in the oxide dielectric thin film is achieved by using a single crystal as a substrate and selecting conditions for film formation so that the crystal structure of the substrate affects the orientation of crystal axes of each crystal in the oxide dielectric thin film. In the processes, the substrate is treated prior to film formation only by washing the substrate surface using, for example, acetone, alcohol and the like in order to remove impurities except elements which constitute the substrate.

However, when an oxide dielectric thin film is formed from a metal alkoxide on a substrate which has been subjected only to washing treatment, for example, as described in Japanese Patent Kokai No. 281500/1993, when a lithium niobate thin film is formed on a (001) plane of a single crystal substrate of sapphire by a sol-gel process using lithium methoxyethoxide $LiOC_2H_4OCH_3$ and niobium methoxyethoxide $Nb(OC_2H_4OCH_3)_5$ as starting materials, a lithium niobate thin film in which one of crystal axes of each crystal are oriented in a [001] direction of the sapphire single crystal can be obtained. However, the half-value width in the X-ray diffraction peak by a Cu-K$\alpha$ radiation for a (006) plane of the $LiNbO_3$ thin film is as broad as 2.7 degrees. The broad half-value width means weak orientation of crystal axis. When such the thin film is utilized making use of its properties such as permitivity which differ depending on each crystal axis, the intended characteristic is undesirably relaxed.

The refractive indexes of the lithium niobate film obtained for an ordinary ray ($n_o$) and for an extraordinary ray ($n_e$) are 1.878 and 1.956, respectively. These values are significantly low compared to $n_o$ of 2.628 and $n_e$ of 2.2002 for bulk lithium niobate. This means that the crystal of the thin film is not sufficiently dense and many grain boundaries exist between crystals. When such a thin film is used, it encounters the problem that the characteristics which are inherent in the material cannot be developed in the thin film, particularly in optical applications.

Thus, oxide dielectric thin films formed by the conventional processes have insufficient orientation and cannot necessarily develop its characteristics.

Epitaxial $LiNbO_3$ thin films prepared by a sol-gel process are described in a paper by Keiichi Nashimoto and Michael J. Cima published in Materials Letters, vol. 10, no. 7, 8, January 1991, pp. 348-354. According to this document $LiNbO_3$ thin films were prepared on sapphire substrates by a sol-gel process using lithium ethoxide and niobium pentaethoxide. Decreasing the amount of water added for hydrolysis of the alkoxides caused the films to show a higher preferred orientation in the same crystal plane as the orientation of the substrate. Without the addition of water to the alkoxides, a heteroepitaxial film with single-crystal nature was obtained.

A paper by Shin-ichi Hirano, Toshinobu Yogo and Ko-ichi Kikuta which was published in Third Euro-Ceramics, vol. 2, pp. 685-698 relates to processing of better ferroelectric films through chemistry. In this document examples are given for epitaxial ferroelectric films of $LiNbO_3/Ti$, $Pb(Zr,Ti)O_3$, $Pb(Mg,Nb)O_3$, $K(Ta,Nb)O_3$ and $(Sr,Ba)Nb_2O_6$ from metal alkoxide precursors. Crystalline epitaxial films with stoichiometry could be synthesized through the reaction control of the intermediate state of starting metal alkoxide moleculs in solution.

US-4,946,710 relates to a method for producing thin films suitable for fabricating ferroelectric thin films. The method involves preparing a mixture suitable for spin deposition on substrates, comprising the steps of

a) solubilizing amounts of two or more precursors of lead, titanium, zirconium and lanthanum,

b) mixing the metal precursors and solvents,

c) adding an amount of water to resulting solution sufficient to begin a hydrolysis reaction without causing precipitation of solids, and

d) boiling the mixture at a temperature sufficient to vaporize said solvents and aziotrope water to increase the viscosity suitable for spin coating.

## SUMMARY OF THE INVENTION

It is an object of the present invention to provide a process for preparing an oxide dielectric thin film which is excellent in orientation and crystallinity.

The present invention provides a process for preparing an oxide dielectric thin film comprising the steps of treating a substrate surface by hydroxylation and then forming an oxide dielectric thin film on the surface using at least one compound selected from the group consisting of metal alkoxides and metal salts of organic acids.

The substrate used is preferably a single crystal.

The oxide dielectrics which can form a thin film according to the present invention are metal oxides having dielectric characteristics such as $LiNbO_3$, $Li_2B_4O_7$, $Pb(Zr,Ti)O_3$, $BaTiO_3$, $SrTiO_3$, $(Pb,La)(Zr,Ti)O_3$, $LiTaO_3$, $ZnO$, $Ta_2O_5$, etc. A thickness of the formed film is not particularly limited, however is usually in a range of 5 nm to 50 µm, preferably 30 nm to 5 µm.

## DETAILED DESCRIPTION OF THE INVENTION

The substrate used in the present invention is a single crystal substrate since crystallinity of the substrate is intended to be transmitted to the oxide dielectric thin film. Therefore, silicon, sapphire, quartz, magnesium oxide, strontium titanate, and the like can be used as the substrate.

The term "hydroxylation treatment" means a physical or chemical treatment by which hydroxy groups (OH groups) are formed on a substrate surface.

The hydroxylation treatment is effected, for example, by immersing the substrate in an alkaline solution, or by placing the substrate in a H, O and OH plasma to form hydroxy groups on the substrate surface.

When the hydroxylation treatment is effected by the plasma treatment, an atmosphere which is used for generating plasma should comprise a gas containing at least H, O and OH groups such as steam and optionally additional gases such as Ar, $N_2$ or $H_2$ gas. The gas containing H, O and OH groups is used in order to provide the substrate surface with the OH groups from the atmosphere in which the plasma is generated.

A total pressure of the plasma generating atmosphere is generally in the range of 1,33 Pa (1 mTorr) to 13,3 kPa (100 Torr), preferably 13,3 Pa (10 mTorr) to 2,66 kPa (20 Torr). When the total pressure is too low, the hydroxylating action is insufficient. On the other hand, a too high pressure makes the generation of plasma difficult.

In order to generate the plasma in the above pressure range, an electromagnetic field must be applied. An electromagnetic field of an alternating current is more preferable than that of a direct current since it can generate the plasma in wider pressure range. An electromagnetic field of an alternating current in the range of from 30 kHz to 30 GHz, i.e. high-frequency, is more preferable.

According to the process of the present invention, the oxide dielectric thin film is formed on the substrate which has been subjected to the hydroxylation treatment, using at least one metal alkoxide as the starting material. The metal alkoxide used as the starting material comprises a metal, for example, Li, Nb, B, Pb, Zr, Ti, Ba, Sr, etc. and an alkoxy group, for example, $OCH_3$, $OC_2H_5$, $OC_3H_7$, $OC_4H_9$, $OC_2H_4OCH_3$, etc., depending on the kind of the oxide dielectric to be prepared. Examples of the metal alkoxide are $LiOCH_3$, $Nb(OC_2H_5)_5$, $B(OCH_3)_3$, $Pb(OC_4H_9)_4$, $Zr(OCH_3)_4$, $Zr(OC_2H_5)_4$, $Zr(OC_3H_7)_4$, $Zr(OC_4H_9)_4$, $Ti(OCH_3)_4$, $Ti(OC_2H_5)_4$, $Ti(iso-OC_3H_7)_4$, $Ti(OC_4H_9)_4$, $Ba(OC_2H_5)_2$, $Sr(OC_2H_5)_2$, $LiOC_2H_4OCH_3$, $Nb(OC_2H_4OCH_3)_5$, and combinations thereof.

When a thin film of lithium niobate is formed, a combination of $LiOC_2H_4OCH_3$ and $Nb(OC_2H_4OCH_3)_5$ is preferably used. When a thin film of lithium borate is formed, a combination of $LiOCH_3$ and $B(OCH_3)_3$ is preferably used. When a thin film of $Pb(Zr,Ti)O_3$ is formed, a combination of $Pb(iso-OC_3H_7)_4$, $Zr(iso-OC_3H_7)_4$ and $Ti(iso-OC_3H_7)_4$ is preferably used. When a thin film of $BaTiO_3$ is formed, a combination of $Ba(iso-OC_3H_7)_2$ and $Ti(iso-OC_3H_7)_4$ is preferably used. When a thin film of $SrTiO_3$ is formed, a combination of $Sr(iso-OC_3H_7)_2$ and $Ti(iso-OC_3H_7)_4$ is preferably used.

According to the process of the present invention, the oxide dielectric thin film can be formed on the substrate preferably by a sol-gel process or a chemical vapor phase propagation process.

The sol-gel process is a process in which a metal is dissolved or dispersed in a solvent in the form of an alkoxide or a salt thereof and converted through the forms of sol and gel into a solid oxide thereof, for example, by heat-treating. When the sol-gel process is applied to the process according to the present invention, a coating sol is prepared, for example, by optionally adding water and an additive such as hydrochloric acid, nitric acid, an amine or acetic acid to an alcoholic solution of at least one metal alkoxide, e.g., $LiOC_2H_5$ and $Nb(OC_2H_5)_5$, and optionally heating the solution to a temperature range up to reflux temperature. The coating sol thus obtained is coated on a substrate surface by spin coating, dip coating, etc., and is dried, oxidized and crystallized by heating it at a temperature of 300 to 700°C for 0.5 to 10 hours to form the intended oxide dielectric thin film.

When the orientation of crystal axes of each crystal in the oxide dielectric thin film is intended to be controlled during the formation of the oxide dielectric thin film on the single crystal substrate, sufficient bonds should be present at an interface between the single crystal substrate and the oxide dielectric thin film to transmit the crystallinity of the single crystal to the thin film.

When an oxide dielectric thin film is formed on a single crystal substrate comprising a metal element M' using a metal alkoxide M-O-R in which M represents a metal element atom, O represents an oxygen atom and R represents an alkyl group, M-O-M' bonds can be formed at the interface to transmit the crystal structure of the substrate to the crystallinity of the oxide dielectric thin film. However, in this case, since the reactivity of untreated or conventionally treated surfaces with the metal alkoxide is low, the formation of the M-O-M' bonds is not so easy. Accordingly, a considerably long time is required for the formation of the M-O-M' bonds, and the crystallinity of the substrate can be transmitted only to a limited extent.

On the other hand, when the hydroxylation treatment is effected on the single crystal surface prior to the formation of the oxide dielectric thin film thereon, hydroxyl groups (M'-OH) are formed on the substrate surface. The existence of the hydroxy groups on the substrate surface increases the reactivity of the substrate portion with the metal alkoxide. Thus, when a metal alkoxide starting material is supplied to the substrate surface on which the hydroxyl groups have been formed, the following reaction takes place to accelerate the formation of the M-O-M' bonds:

$$M\text{-}O\text{-}R + M'\text{-}OH \rightarrow M\text{-}O\text{-}M' + ROH$$

Then, the element M constituting the oxide dielectric thin film is arranged in a state that it is constrained by the element M' constituting the substrate. As a result, the crystal structure of the substrate is easily transmitted to the crystallinity of the oxide dielectric thin film to provide the oxide dielectric thin film which has an excellent orientation and crystalinity.

When the sol-gel process is applied to the process according to the present invention, since it is possible to form a thin film in a condition which is close to a chemical equilibrium, the hydroxy groups existing on the substrate surface are not destroyed during the film forming process to efficiently accelerate the reaction of the formation of the M-O-M' bonds.

When a chemical vapor phase propagation process is applied to the process according to the present invention, for example, at least one metal alkoxide such as Zr (iso-OC$_3$H$_7$)$_4$ as a starting material is subjected to bubbling with Ar, N$_2$ or H$_2$ gas, and O$_2$ gas is simultaneously introduced into a reactor to adjust a total pressure at 1,33 Pa (1 mTorr) to 13,3 kPa (100 Torr), preferably 133 Pa (0.1) to 2,66 KPa (20 Torr). At this time, a substrate is heated to a temperature of 300 to 1,000°C, preferably 400 to 700°C to cause reactions to form the intended oxide dielectric thin film.

In the crystals of oxide dielectrics, the atomic density in planes in a C-axis direction is high and the planes usually consist only of metal element atoms or only of oxygen atoms. Therefore, it is possible to increase the density of bonding at the interface between a single crystal substrate and an oxide dielectric thin film in the C-axis direction to combine them efficiently. Hence, both the direction of the single crystal substrate surface and the direction of orientation of the oxide dielectric thin film are preferably the same as the direction of C-plane. This can be generally achieved by using as a substrate a single crystal having a similar crystal structure to that of the oxide dielectric and preparing the substrate in a manner that the C-plane is on a substrate surface.

The present invention can also be applied to a sol-gel process using at least one metal salt of an organic acid such as lead acetate, yttrium stearate, barium oxalate or yttrium nitrate, in place of, or in addition to the metal alkoxide.

## EXAMPLES

The present invention will be illustrated more specifically by Examples hereinafter, but is not limited thereto.

## Example 1

A thin film of lithium niobate was formed on a single crystal substrate of sapphire by a sol-gel process using metal alkoxides as starting materials and evaluated.

A metal alkoxide containing solution to be used in the sol-gel process (referred to as "precursor solution" hereinafter) was prepared as follows: Each ethanolic solution of Nb(OC$_2$H$_4$OCH$_3$)$_5$ and LiOC$_2$H$_4$OCH$_3$ having a concentration of 0.05 mol/l was mixed and the resulting solution was refluxed at 78.5°C for 24 hours, followed by further reflux for 24 hours after the addition of water (0.05 mol/l). The solution was then concentrated to obtain a solution having a concentration of each alkoxide of 0.5 mol/l. The solution was used as the precursor solution.

A (001) plane or (012) plane single crystal of sapphire which had been subjected to mirror polishing was used as a substrate. It was pretreated in the following order: i.e., ultra-sonic cleaning in acetone, hydrochloric acid (20 vol %) treatment, pure water washing and drying.

Hydroxylation treatment of the substrate surface was effected by means of a plasma treatment. That is, the pretreated substrate as described above was placed in an evacuating vessel and the vessel was evacuated to 1,33 Pa (1 mTorr). Moist air gas which had been passed through water of 35°C was then introduced into the vessel to a pressure of 39,9 Pa (30 mTorr). A high-frequency of 13.56 MHz and 100 W was applied to the system to generate plasma and the substrate was plasma-treated. The partial pressure of steam was about 10 % of the total pressure of the system.

After the above precursor solution was spin-coated at 2,000 rpm on the substrate, the substrate was heated to 600°C at a rate of 10°C/min. under an oxygen atmosphere and maintained at 600°C for 2 hours to obtain a lithium niobate thin film having a thickness of 1000 Å.

Crystallinity of the obtained thin film was evaluated by a half-value width in a X ray diffraction peak obtained by a Cu-Kα radiation for each orientation plane. It was found that smaller the half-value width was, better orientation of the thin film as well as its crystallinity were.

The [001] axis of each crystal in the lithium niobate thin film formed on the (001) plane of the single crystal substrate of sapphire was oriented in a [001] direction of the sapphire single crystal. The half-value width in the X ray diffraction peak for a (006) plane was 0.6 degree. The [012] axis of each crystal in the lithium niobate thin film formed on the (012) plane in the single crystal substrate of sapphire was oriented in a [012] direction of the sapphire single crystal. The half-value width in the X ray diffraction peak for the (012) plane was 0.85 degree.

Comparative Example 1

For comparison, thin films of lithium niobate were formed, on a (001) plane and a (012) plane of a single crystal substrate of sapphire, respectively, which had been pretreated as described above, but not to the hydroxylation treatment.

The [001] axis of each crystal in lithium niobate thin film formed on the (001) plane of the single crystal substrate of sapphire was oriented in a [001] direction in the sapphire single crystal. The half-value width in the X ray diffraction peak for a (006) plane was 0.95 degree. The [012] axis of each crystal in the lithium niobate thin film formed on the (012) plane in the single crystal of sapphire was oriented in a [012] direction of the sapphire single crystal. The half-value width in the X ray diffraction peak for the (012) plane was 1.1 degree.

Example 2

A thin film of lithium niobate was formed on a single crystal substrate of quartz by a sol-gel process using metal alkoxides as starting materials and evaluated. Film forming, pretreatment and hydroxylation treatment of the substrate and evaluation of the obtained film were effected in the same manner as in Example 1.

A thin film of lithium niobate was formed on a (001) plane of the single crystal substrate of quartz. The [001] axis of each crystal in the obtained lithium niobate thin film was oriented in a [001] direction of the quartz single crystal. The half-value width in the X ray diffraction peak for a (006) plane was 0.95 degree.

Comparative Example 2

Thin film of lithium niobate was formed using the similar method to that in Example 2 on a (001) plane of the single crystal substrate of quartz which had been pretreated as described above, however not been subjected to hydroxylation treatment

The [001] axis of each crystal in the obtained thin film of lithium niobate was oriented in a [001] direction of the quartz single crystal. However, the half-value width in the X ray diffraction peak for a (006) plane was 1.8 degrees.

As described above, in the formation of an oxide dielectric thin film on a single crystal substrate, when hydroxylation treatment of the substrate surface is effected prior to the forming of the oxide dielectric thin film, the oxide dielectric thin film having excellent orientation and crystalinity in comparison to conventional oxide dielectric thin films can be prepared.

**Claims**

1. A process for preparing an oxide dielectric thin film comprising the steps of treating a substrate surface by hydroxylation and then forming an oxide dielectric thin film on the surface using at least one compound selected from the group consisting of metal alkoxides and metal salts of organic acids.

2. A process as claimed in Claim 1, wherein the substrate surface is treated by hydroxylation with a plasma.

3. A process as claimed in Claim 1, wherein the oxide dielectric thin film is formed by a sol-gel process.

4. A process as claimed in Claim 1, wherein a direction of orientation of the oxide dielectric thin film and a direction of the substrate surface are the same as a direction of a C-plane.

5. A process as claimed in Claim, 1 wherein the oxide dielectric is lithium niobate.

6. A process as claimed in Claim 1, wherein the substrate is selected from the group consisting of silicon, sapphire, quartz, magnesium oxide and strontium titanate.

**Patentansprüche**

1. Verfahren zur Herstellung einer Oxiddielektrikum-Dünnschicht, das die Schritte einer Behandlung einer Substratoberfläche durch Hydroxylierung und dann Ausbilden einer Oxiddielektrikum-Dünnschicht auf der Oberfläche unter Verwendung mindestens einer Verbindung, die aus der Gruppe bestehend aus Metallalkoxiden und Metallsalzen organischer Säuren ausgewählt wird, umfaßt.

**2.** Verfahren nach Anspruch 1, wobei die Substratoberfläche durch Hydroxylierung mit einem Plasma behandelt wird.

**3.** Verfahren nach Anspruch 1, wobei die Oxiddielektrikum-Dünnschicht durch ein Sol-Gel-Verfahren gebildet wird.

**4.** Verfahren nach Anspruch 1, wobei eine Orientierungsrichtung der Oxiddielektrikum-Dünnschicht und eine Richtung der Substratoberfläche dieselben wie eine Richtung einer C-Ebene sind.

**5.** Verfahren nach Anspruch 1, wobei das Oxiddielektrikum Lithiumniobat ist.

**6.** Verfahren nach Anspruch 1, wobei das Substrat aus der Gruppe bestehend aus Silicium, Saphir, Quarz, Magnesiumoxid und Strontiumtitanat ausgewählt wird.

**Revendications**

**1.** Procédé de préparation d'un mince film diélectrique d'oxyde, comprenant les étapes consistant à traiter la surface d'un support par hydroxylation et à former ensuite un mince film diélectrique d'oxyde sur la surface en utilisant au moins un composé choisi dans le groupe formé d'alkoxydes de métaux et de sels de métaux d'acides organiques.

**2.** Procédé selon la revendication 1, dans lequel la surface du support est traitée par hydroxylation à l'aide d'un plasma.

**3.** Procédé selon la revendication 1, dans lequel le mince film diélectrique d'oxyde est formé par un procédé par sol-gel.

**4.** Procédé selon la revendication 1, dans lequel une direction d'orientation du mince film diélectrique d'oxyde et une direction de la surface du support sont les mêmes qu'une direction d'un plan C.

**5.** Procédé selon la revendication 1, dans lequel le diélectrique d'oxyde est du niobate de lithium.

**6.** Procédé selon la revendication 1, dans lequel le support est choisi dans le groupe formé du silicium, du saphir, du quartz, de l'oxyde de magnésium et du titanate de strontium.